# EUROPÄISCHE PATENTSCHRIFT

(11) **EP 3 293 532 B1**
(45) Veröffentlichungstag und Bekanntmachung des Hinweises auf die Patenterteilung: **27.04.2022**
(21) Anmeldenummer: 17189164.1
(22) Anmeldetag: 04.09.2017
(51) Int. Cl.: G01R 31/11

(54) **VORRICHTUNG ZUR ORTUNG EINER STÖRSTELLE AN EINEM LEITER**
DEVICE FOR LOCATING A FAULT ON A CONDUCTOR
DISPOSITIF DE LOCALISATION D'UN DÉFAUT SUR UN CONDUCTEUR

(30) Priorität: 07.09.2016 DE 102016116719
(43) Veröffentlichungstag der Anmeldung: 14.03.2018
(73) Patentinhaber: MS-Technik Mess- und Regelungstechnik GmbH & Co. KG, 24232 Schönkirchen (DE)
(72) Erfinder: Schacht, Sebastian, 24248 Mönkeberg (DE)
(74) Vertreter: Eisenführ Speiser

(56) Entgegenhaltungen:
- EP-A1- 0 274 347
- CN-A- 1 444 048
- DE-A1-102011 009 512
- KR-A- 20130 005 803
- US-A- 2 808 566
- US-A1- 2002 053 914
- US-A1- 2007 204 686
- US-A1- 2010 171 483
- US-A1- 2014 222 356
- US-A1- 2015 160 283
- US-A1- 2016 139 195
- J (jeroen) Veen: "On-line signal analysis of partial discharges in medium-voltage power cables", , 1. Januar 2005 (2005-01-01), XP055118939, DOI: 10.6100/IR586076 Gefunden im Internet: URL:http://dx.doi.org/10.6100/IR586076 [gefunden am 2018-01-18]

## Beschreibung

Die Erfindung betrifft eine Vorrichtung nach dem Oberbegriff des Anspruches 1.

Eine solche Vorrichtung ist aus der DE 198 30 738 B4 bekannt. Sie dient dazu, auf einem unter Umständen in einem Netz weitläufig verzweigten Leiter eine Störstelle zu suchen, die zum Beispiel als Leitungsunterbrechung oder als Kurzschluss ausgebildet ist und elektrische Impulse reflektiert.

Es wird ein Prüfimpuls auf die Leitung gegeben. Der läuft bis zur Störstelle und wird dort reflektiert. Das reflektierte Signal wird erkannt und es lässt sich aus der Laufzeit der Weg bis zur Störstelle bestimmen, was anhand des Verlegeplans des Netzes die genaue Ortsbestimmung der Störstelle ermöglicht.

In dem meist komplexen Netz ergeben sich Reflexionen nicht nur an einer Störstelle sondern an vielen Stellen des Netzes, wie zum Beispiel am Ende einer Zweigleitung, an einer Verzweigungsstelle oder dergleichen.

Die DE 198 30 738 B4 beschreibt daher die Verwendung einer Lenkeinrichtung, um die Prüfimpulse beim Einkoppeln bevorzugt in Richtung zur Störstelle zu lenken. Dadurch wird im Wesentlichen verhindert, dass die Prüfimpulse auch noch rückwärts in das verzweigte Netz laufen und dort störende Reflexionsimpulse erzeugen.

Die genannte Schrift verwendet zur Koppelung der Impulse auf die Leitung eine Einrichtung mit einem Transformator, der induktiv an die Leitung und an eine Nebenleitung koppelt, zwischen denen zusätzlich eine kapazitive Koppelung vorgesehen ist. Die induktive Koppelung des Transformators an die Leitung bildet eine in der Leitung sitzende Drossel aus.

Diese Drossel muss in Reihe mit der mit dem Prüfimpuls zu beaufschlagenden Leitung sitzen und wird von deren Strom durchflossen. Leitungen in Leitungsnetzen, zum Beispiel in Niederspannungsnetzen der öffentlichen Stromversorgung müssen aber hohe Stromlasten bis zu - besonders im Fall gestörter Leitungen, der hier besonders zu berücksichtigen ist - viele tausende Ampere tragen. Entsprechend belastbare Drosseln sind aber für die praktische Anwendbarkeit zu groß, zu schwer und zu teuer.

Diese Konstruktion einer Lenkeinrichtung ist außerdem, wie schon ein Blick auf den Anspruch 1 der zitierten Schrift ergibt, außerordentlich komplex und hinsichtlich ihrer Vor- und Nachteile somit schwer einschätzbar. Auch Entwurf und Gestaltung einer so komplexen Schaltung ist äußerst aufwendig. So sind unter anderem auch galvanische Verbindungen erforderlich, die die Schaltung sehr aufwendig machen.

Die zitierte Schrift erwähnt ferner in [0003] eine Einrichtung zum Absperren des rückwärtigen Teiles des Netzes mit einer Impulssperre in Form einer Drossel, die ebenfalls in Reihe mit der Leitung sitzt und dieselben Nachteile ergibt.

Besonders störend sind die beiden folgenden Nachteile:
Die als Impulssperre dienende Drossel ist groß und schwer. Das ergibt erhebliche Probleme beim Transport der Ortungsvorrichtung und bei ihrem Einbau.
Die Drossel muss zudem in Reihe mit der Leitung liegen und erfordert daher zu ihrem Einbau eine Auftrennung der Leitung und somit eine Netzunterbrechung, die eine an sich wünschenswerte, vom Ortungsvorgang ungestörte Weiterbenutzung des Netzes verhindert.

Die zitierte Schrift geht in ihrer Beschreibungseinleitung auf weiteren Stand der Technik ein, der solche Lenkeinrichtung (Richtkoppler) auf ähnlichen oder benachbarten Gebieten zeigt. Es sind die jeweiligen Nachteile diskutiert. Weiterhin offenbaren die Dokumente CN 1 444 048 A, US 2002/053914 A1, US 2015/160283 A1 und "On-line signal analysis of partial discharges in medium-voltage power cables", J. Veen, 1. Januar 2005, Vorrichtungen zur Überwachung einer elektrischen Leitung.

Die Aufgabe der vorliegenden Erfindung besteht darin, eine Vorrichtung der eingangsgenannten Art zu schaffen, die einfacher und übersichtlicher gestaltbar ist und auch hinsichtlich Bauaufwand und Gewicht, sowie Betriebsbehinderungen Vorteile aufweist.

Diese Aufgabe wird mit den Merkmalen des Anspruches 1 gelöst.

Erfindungsgemäß wird zum Abblocken des rückwärtigen Teiles des Netzes ein Kondensator verwendet, der die hochfrequenten Anteile des Prüfimpulses kurzschließt und somit unterdrückt. Ein solcher Kondensator wird nur mit den Prüfimpulsen belastet, nicht aber mit der Transportleistung des Netzes. Er kann somit sehr klein und leicht sowie auch kostengünstig sein. Alle eventuell entstehenden Impulsreflektionen aus dem rückwärtigen Teil des Netzes werden vollständig verhindert. Die Schaltung ist sehr einfach und hinsichtlich ihrer Auslegung leicht beherrschbar. Die erfindungsgemäße Vorrichtung lässt sich insgesamt sehr klein und leicht bauen. Beim Einbau der Lenkeinrichtung ist keine Auftrennung der Leitung und somit keine Netzunterbrechung erforderlich. Das ermöglicht einen störungsfreien Weiterbetrieb des Netzes. Die Ein- und Auskopplung kann rein induktiv gehalten sein. Sie kann berührungslos gestaltet werden, sodass Eingriffe an der Isolierung nicht erforderlich sind. Auch hierdurch wird der störungsfreie Weiterbetrieb gesichert.

Die Auskoppeleinrichtung die den rücklaufenden Echoimpuls auskoppelt, kann irgendwo im Netz angeordnet sein. Dabei können sich allerdings Zuordnungsprobleme bei den Impulsen ergeben. Vorteilhaft gemäß Anspruch 2 liegt die Auskoppeleinrichtung möglichst eng bei der Einkoppeleinrichtung. Dann ergeben sich einfache und übersichtliche Verhältnisse, insbesondere hinsichtlich der Signalauswertung. Es lassen sich auch Teile der Einrichtungen gemeinsam benutzen und somit Einsparungen erzielen.

Es kann sogar eine Koppeleinrichtung so gestaltet werden, dass sie sowohl das Einkoppeln als auch das Auskoppeln übernimmt. Dabei müsste nur auf zeitliche Trennung der Vorgänge geachtet werden. Vorteilhaft gemäß Anspruch 3 sind aber die Koppeleinrichtungen getrennt ausgebildet. Der erhöhte bauliche Aufwand wird durch Vorteile bei der konstruktiven und elektrischen Auslegung der beiden Einrichtungen aufgewogen, die für die jeweiligen Anwendungen getrennt besser optimiert werden können.

Wie auch der zitierte Stand der Technik zeigt, eignen sich zum Ein- und Auskoppeln insbesondere induktiv koppelnde Spulen. Vorteilhaft gemäß Anspruch 4 wird dabei eine der Spulen durch den Leiter mit der Windungszahl eins ausgebildet. Eine der Spulen besteht also aus dem gerade durchlaufenden Leiter. Dadurch wird die Induktivität dieser Spule und auch der technische Konstruktionsaufwand wesentlich verringert.

Dabei ist vorteilhaft gemäß Anspruch 5, als Spule eine Rogowskispule verwendet. Dieser Spulentyp wird im Stand der Technik für sogenannte Stromzangen, also als Strommessgerät verwendet, das an einem Leiter unkompliziert angesetzt und wieder abgenommen werden kann. Diese Spule eignet sich auch für die vorliegenden Zwecke der Signalein- bzw. auskopplung. Galvanische, also elektrisch leitende Verbindungen sind nicht erforderlich. Die Isolierung muss nicht angegriffen werden.

In der Zeichnung ist die Erfindung beispielsweise und schematisch dargestellt. Es zeigen:
- Fig. 1: den schematischen Schaltplan eines einfachen Versorgungsnetzes mit zwei Leitern und der erfindungsgemäßen Vorrichtung die mit zwei Rogowskispulen ausgerüstet ist und
- Fig. 2: eine schematische Darstellung einer der in Fig. 1 verwendeten Rogowskispulen.

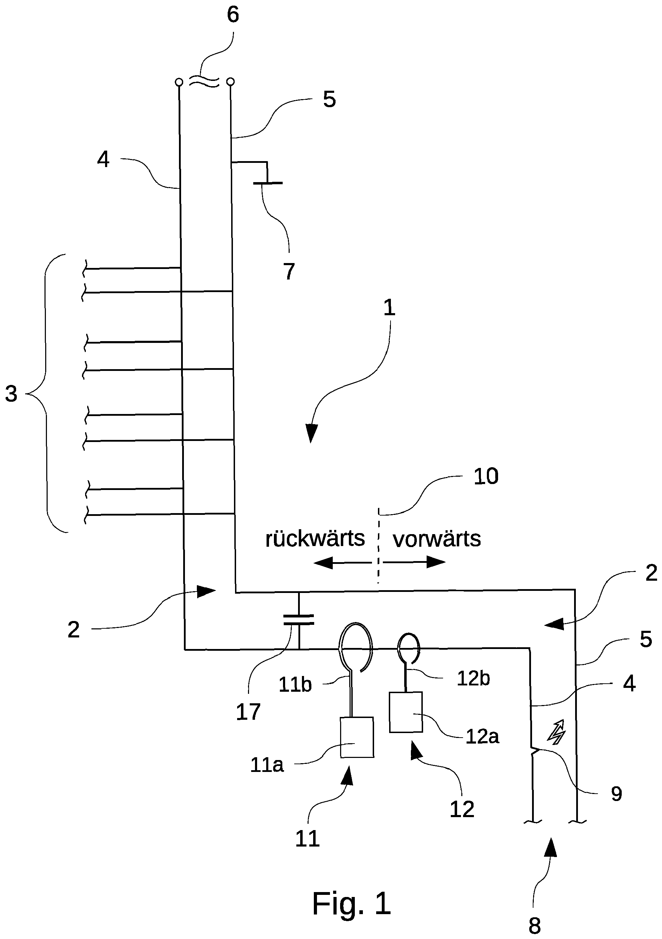

Fig. 1 zeigt die vereinfachte schematische Darstellung eines Teiles eines Leitungsnetzes 1 mit einem Hauptstrang 2, von dem mehrere Seitenstränge 3 abzweigen.

Die Stränge 2, 3 bestehen jeweils aus zwei Leitungen und zwar, wie bei dem Hauptstrang im Einzelnen angegeben, aus einem Phasenleiter 4 und einem Gegenleiter 5. Phasenleiter 4 und Gegenleiter 5 bilden eine zweiphasige Versorgung und sind an die beiden Pole einer Stromquelle 6 angeschlossen zum Beispiel ein Kraftwerk, eine Umspannstation oder dergleichen.

Im dargestellten Ausführungsbeispiel ist der Gegenleiter 5 bei 7 geerdet und bildet in der üblichen Terminologie den Nullleiter. Es können weitere Leiter vorgesehen sein. So weist z.B. ein übliches Niederspannungsnetz einer städtischen Versorgung drei Phasenleiter und einen Nullleiter auf.

Der Hauptstrang 2 des dargestellten Netzes verläuft von den Verzweigungen an den Seitensträngen 3 bis zu einem abgeschnitten dargestellten Ende 8, das in größerer Entfernung liegen kann. An der in Fig. 1 dargestellten und mit einem Blitzsymbol gekennzeichneten Störstelle 9 liegt eine Störung vor, zum Beispiel eine Verletzung der Isolation des Phasenleiters 4. Dort kann sich zwischen dem Leiter 4 und der Umgebung oder zum Gegenleiter 5 ein Kurzschluss bilden, der gefunden werden soll.

Mit einer gestrichelten Linie 10 ist eine Kopplungsposition markiert. An dieser bzw. eng benachbart, sind eine Einkopplungseinrichtung 11 und eine Auskopplungseinrichtung 12 angeordnet. Beide bestehen jeweils aus einer Elektronikanordnung in einem Gehäuse 11a bzw. 12a und einer daran angeschlossenen Rogowskispule 11b bzw. 12b.

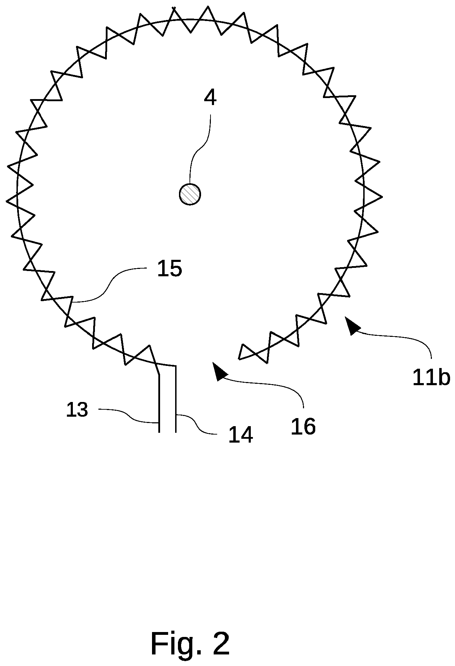

Zur Erläuterung zeigt Fig. 2 vergrößert eine Rogowskispule, zum Beispiel die Rogowskispule 11b aus Fig. 1.

Die Rogowskispule weist zwei Zuleitungen 13 und 14 auf, die, wie der Vergleich mit Fig. 1 zeigt, an die Gehäuse 11a, 12a angeschlossen sind. Je nachdem ob die Rogowskispule als Sendespule oder als Empfangsspule dient, ist in dem verbundenen Gehäuse dann ein Sender oder ein Empfänger anzuordnen. Bei kombinierter Ausbildung kann eine Rogowskispule beiden Zwecken dienen. Im Gehäuse ist dann eine Sende-Empfangseinrichtung anzuordnen, die umschaltbar zunächst sendet und anschließend empfängt.

Die Zuleitung 13 ist an ein Ende einer Spule 15 angeschlossen, die in der Fig. 2 schematisch mit einer Zick Zack Linie angedeutet ist, tatsächlich aber in einer Schraubenlinie verläuft und insgesamt kreisförmig ausgebildet ist, wie die Fig. 2 zeigt.

Die Zuleitung 14 verläuft mit der Spule 15 und ist mit ihrem Ende an deren Ende verbunden.

Die dargestellt Rogowskispule hat also einen Anfang und ein Ende. Dazwischen befindet sich eine Lücke 16. Mit dieser kann die Rogowskispule ohne Berührung in und außer Eingriff mit dem durchgehenden Leiter 4 gebracht werden, der im Vergleich mit Fig. 1 die Anordnung verdeutlicht.

Wie Fig. 1 zeigt, sind nebeneinander die Einkopplungseinrichtung 11 und die Auskopplungseinrichtung 12 angeordnet, die jeweils mit ihrer Rogowskispule in benachbarter Anordnung den Leiter 4 umschließen.

Beim Betrieb dieser Kopplungseinrichtung 11, 12 erzeugt zunächst die Einkopplungseinrichtung 11 einen Impuls auf den Leiter 4. Dieser läuft vorwärts und rückwärts. Die beiden Richtungen "vorwärts" und "rückwärts" sind in Bezug auf die gestrichelte Linie 10 in Fig. 1 jeweils mit einem Pfeil angegeben. Der von der Einkopplungseinrichtung 11 erzeugte Impuls läuft also auch vorwärts bis zur Störstelle 9 und wird dort reflektiert.

Der reflektierte Impuls läuft auf der Leitung 4 rückwärts und wird von der Auskopplungseinrichtung 12 ausgekoppelt und der Elektronik im Gehäuse 12a zur Erkennung und Auswertung zugeführt. Eine an die Einkopplungseinrichtung 11 und an die Auskopplungseinrichtung 12 angeschlossene, in der Zeichnung nicht dargestellte Auswerteinrichtung kann die Zeit zwischen dem Einkoppeln eines Prüfimpulses durch die Einkopplungseinrichtung 11 und dem Empfang des reflektierten Echoimpulses an der Auskopplungseinrichtung 12 bestimmen und daraus die auf dem Leiter 4 zurückgelegte Strecke errechnen, womit der Ort der Störstelle 9 ermittelbar ist.

In dem dargestellten sehr einfachen Netz können eine ganze Anzahl störender Sekundärimpulse auftreten. Wenn an der Störstelle 9 keine vollständige Unterbrechung vorliegt, sondern der Prüfimpuls dort noch weiterlaufen kann, so kann er an dem nichtdargestellten Ende 8 reflektiert werden und einen zweiten späteren Echoimpuls ergeben.

In den Seitensträngen 3 des Leitungsnetzes 1 können ebenfalls störende Echoimpulse auftreten, zum Beispiel an den Enden dieser Seitenstränge oder an den Abzweigstellen. Dadurch kann sich ein sehr verwirrendes schwer auswertbares Echobild ergeben.

Erfindungsgemäß wird rückwärts von der gestrichelten Linie, also rückwärts von den Kopplungseinrichtungen 11 bzw. 12 ein Kondensator 17 zwischen den Leitungen 4 und 5 angeordnet. Der Kondensator 17 ergibt für höherfrequente Signale, also insbesondere die Prüfimpulse und die daraus entstehende Echoimpulse einen Kurzschluss. Bei niederen Frequenzen, also insbesondere bei der Netzfrequenz eines üblichen Versorgungsnetzes stört der Kondensator 17 nicht. Er wird dadurch auch nicht belastet.

Betrachtet man die Kopplungsanordnung mit der Einkopplungseinrichtung 11 und der Auskopplungseinrichtung 12, sowie mit dem Kondensator 17 näher, so sieht man, dass im Falle des normalen Netzbetriebes ohne Prüfimpulse die Anordnung so funktioniert, als sei der Kondensator 17 nicht vorhanden.

Betrachtet man den Betrieb mit Prüfimpulsen, so kann zum Verständnis der Funktion das Netz weggelassen werden. An der Stelle des Kondensators 17 befindet sich ein Kurzschluss zwischen den Leitern 4 und 5. Die rückwärtigen Enden des Netzes sind hinter dem Kondensator 17 nicht wahrnehmbar und können zur Betrachtung der Funktion vernachlässigt werden.

Man erkennt, dass die mit der Erfindung vorgelegte Schaltung einen idealen Richtkoppler ausbildet, der alle Teile des Netzes, die rückwärts von der Kopplungsstelle liegen, also rückwärts vom Kondensator 17, völlig unterdrückt.

Alle störenden Reflexionen im rückwärtigen Netz werden mit dem Kondensator 17 abgefangen. Einzig Störungen aus dem vorderen Teil des aus den Leitern 4 und 5 bestehenden Stranges können stören. Wenn diese Störungen aber von Störstellen stammen, die jenseits der Störstelle 9 liegen, so lassen sie sich ganz einfach durch Zeitvergleich ermitteln und aussortieren.

Fig. 1 zeigt, dass die Einkopplungseinrichtung 11, die Auskopplungseinrichtung 12 und der Kondensator 17 die Ortungsvorrichtung bilden. Lässt man diese Teile weg, so hat man ein übliches Leitungsnetz.

Man könnte die Ortungsvorrichtung 11, 12 und 17 schon beim Bau des Leitungsnetzes einbauen. Das wird aber aus Kostengründen vermieden. Der Normalfall des Einbaues einer Ortungsvorrichtung ist also der nachträgliche vorübergehende Einbau in ein in Betrieb befindliches Netz.

Dabei ist von großem Vorteil, dass nicht gemäß dem Stand der Technik eine große und schwere Drossel in Reihenschaltung eingebaut werden muss, was eine Auftrennung der Leitung und damit eine Netzunterbrechung bewirkt. Vielmehr wird erfindungsgemäß nur der kleine und leichte Kondensator 17 aufgeschaltet, was ohne jede Störung des Betriebes möglich ist.

Berücksichtigt man bei diesen Überlegungen noch die in Fig. 1 aus Gründen der Vereinfachung nicht eingezeichnete Verbraucherlast, die als sehr niederohmige Impedanz zwischen den Leitungen 4 und 5 dargestellt werden könnte, so sieht man, dass der Kondensator 17 parallel zu dieser Last liegt.

Würde man stattdessen eine Drossel als Impulssperre nach dem Stand der Technik verwenden, so läge diese Drossel in Reihe mit der Last und könnte nicht ohne Unterbrechung eingebaut werden.

Die Einkopplungseinrichtung 11 und die Auskopplungseinrichtung 12 sind vorteilhaft, wie in den Figuren dargestellt, mit den Rogowskispulen 11b und 12b an den Phasenleiter 4 gekoppelt. Diese Ankopplung ist, wie Fig. 2 zeigt, vollständig Berührungsfrei.

### Bezugszeichenliste

- 1: Leitungsnetz
- 2: Hauptstrang
- 3: Seitenstrang
- 4: Phasenleiter
- 5: Gegenleiter
- 6: Stromquelle
- 7: Erde
- 8: Ende
- 9: Störstelle
- 10: Gestrichelte Linie
- 11: Einkopplungseinrichtung
- 11a: Gehäuse
- 11b: Rogowski Spule
- 12: Auskopplungseinrichtung
- 12a: Gehäuse
- 12b: Rogowski Spule
- 13: Zuleitung
- 14: Zuleitung
- 15: Spule
- 16: Lücke
- 17: Kondensator

## Patentansprüche

1. Vorrichtung zur Ortung einer Störstelle (9) an einem Leiter (4) eines wenigstens einen Phasenleiter (4) und wenigstens einen Gegenleiter (5) aufweisenden elektrischen Leitungsnetzes (1) für die Versorgung mit Strom einer üblichen Netzfrequenz, wobei der Phasenleiter (4) mit Wechselstrom beaufschlagt und im Betrieb befindlich ist, mit einer Einrichtung (11) zur Einkoppelung wenigstens eines Prüfimpulses in den Phasenleiter (4) und einer Einrichtung (12) zur Auskopplung von an der Störstelle (9) reflektierten Echoimpulsen aus dem Phasenleiter (4), sowie mit einer Lenkeinrichtung (17), um die Impulse wenigstens bevorzugt in Richtung vorwärts zur Störstelle (9) zu koppeln, wobei die Einrichtungen (11, 12) zur Einkoppelung bzw. Auskoppelung jeweils induktiv koppelnd ausgebildet sind und dass die Lenkeinrichtung als rückwärts von den Einkoppeleinrichtungen (11, 12) zwischen dem Phasenleiter (4) und dem Gegenleiter (5) angeordneter Kondensator (17) ausgebildet ist, wobei der Kondensator (17) ausgeführt ist, für die höherfrequenten Signale der Prüfimpulse und die daraus entstehende Echoimpulse einen Kurzschluss zu ergeben, und bei niederen Frequenzen, nämlich bei der Netzfrequenz eines üblichen Versorgungsnetzes, nicht zu stören.

2. Vorrichtung nach Anspruch 1, wobei die Einkoppeleinrichtung (11) und die Auskoppeleinrichtung (12) wenigstens im Wesentlichen an derselben Stelle (10) am Phasenleiter (4) angreifend angeordnet sind.

3. Vorrichtung nach einem der vorhergehenden Ansprüche, wobei die Koppeleinrichtungen (11, 12) getrennt voneinander ausgebildet sind.

4. Vorrichtung nach einem der vorhergehenden Ansprüche, wobei wenigstens eine der Koppeleinrichtungen (11, 12) zwei miteinander magnetisch koppelnde Spulen aufweist, wobei der Phasenleiter (4) eine der Spulen mit der Windungszahl eins ausbildet.

5. Vorrichtung nach Anspruch 4 , wobei die andere Spule als Rogowskispule (11b, 12b) ausgebildet ist.

## Claims

1. Apparatus for locating a fault (9) on a conductor (4) of an electrical cable network (1) having at least one phase conductor (4) and at least one counter-conductor (5), said cable network supplying power at a customary network frequency, wherein the phase conductor (4) is exposed to alternating current and is in operation, having a mechanism (11) for coupling at least one test pulse in the phase conductor (4) and a mechanism (12) for decoupling echo pulses reflected at the fault (9) from the phase conductor (4), and also having a guidance mechanism (17) for coupling pulses at least preferably in the forwards direction to the fault (9), wherein the mechanisms (11, 12) for coupling or decoupling each have an inductively coupling design and the guidance mechanism is designed as a capacitor (17) arranged backwards from the coupling mechanisms (11, 12) between the phase conductor (4) and the counter-conductor (5), wherein the capacitor (17) is configured to produce a short circuit for the higher frequency signals of the test pulses and the echo pulses resulting from these, and not to cause any interruption at lower frequencies, namely at the network frequency of a conventional supply network.

2. The device according to Claim 1, wherein the coupling mechanism (11) and the decoupling mechanism (12) are arranged for engagement at least substantially at the same point (10) on the phase conductor (4).

3. The device according to one of the preceding claims, wherein the coupling mechanisms (11, 12) are designed to be separate from one another.

4. The device according to one of the preceding claims, wherein at least one of the coupling mechanisms (11, 12) has two coils which are magnetically coupled with one another, wherein the phase conductor (4) forms one of the coils with the winding number one.

5. The device according to Claim 4, wherein the other coil is designed as a Rogowski coil (11b, 12b).

## Revendications

1. Dispositif de localisation d'une perturbation (9) dans un conducteur (4) d'un réseau de distribution électrique (1) comportant au moins un conducteur de phase (4) et au moins un contre-conducteur (5) pour l'alimentation en courant électrique de fréquence de réseau usuelle - le conducteur de phase (4) étant en service sous courant alternatif - avec un dispositif (11) d'injection d'au moins une impulsion de contrôle dans le conducteur de phase (4) et un dispositif (12) de découplage d'impulsions d'écho réfléchies dans le conducteur de phase (4) par le point de perturbation (9), et avec un dispositif de guidage (17) pour injecter les impulsions au moins de préférence en direction du point de perturbation (9), les dispositifs (11, 12) d'injection et de découplage étant respectivement conçus pour un couplage inductif, et le dispositif de guidage étant réalisé sous forme de condensateur (17) placé en amont des dispositifs d'injection (11, 12) entre le conducteur de phase (4) et le contre-conducteur (5), le condensateur (17) étant conçu pour provoquer un court-circuit pour les signaux de fréquence plus élevée des impulsions de contrôle et les impulsions d'écho en résultant, et pour ne pas perturber le réseau en présence de fréquences inférieures, à savoir la fréquence d'un réseau de distribution usuel.

2. Dispositif selon la revendication 1, le dispositif d'injection (11) et le dispositif de découplage (12) étant agencés pour agir au moins essentiellement à la même position (10) sur le conducteur de phase (4).

3. Dispositif selon l'une des revendications précédentes, les dispositifs de couplage (11, 12) étant séparés l'un de l'autre.

4. Dispositif selon l'une des revendications précédentes, l'un au moins des dispositifs de couplage (11, 12) présentant deux bobines couplées magnétiquement, le conducteur de phase (4) formant l'une des bobines avec un nombre de spires un.

5. Dispositif selon la revendication 4, l'autre bobine étant réalisée sous forme d'enroulement de Rogowski (11b, 12b).
